# EUROPEAN PATENT SPECIFICATION

(11) **EP 0 355 522 B1**
(45) Date of publication and mention of the grant of the patent: **15.12.1993**
(21) Application number: 89114371.1
(22) Date of filing: 03.08.1989
(51) Int. Cl.: H01L 31/0203, H04N 1/028, H01L 25/04

(54) **Solid state image pickup device**
Festkörper-Bildaufnahmevorrichtung
Dispositif de prise de vue à corps solide

(30) Priority: 18.08.1988 JP 205542/88; 29.08.1988 JP 214443/88; 29.08.1988 JP 214452/88
(43) Date of publication of application: 28.02.1990
(73) Proprietor: SEIKO EPSON CORPORATION, Shinjuku-ku Tokyo-to (JP)
(72) Inventor: Toda, Shigeo Seiko Epson Corporation, Suwa-shi Nagano-ken (JP)
(74) Representative: Hoffmann, Eckart, Dipl.-Ing.

(56) References cited:
- PATENT ABSTRACTS OF JAPAN, vol. 10, no.317 (E-449)(2373), 28 October 1986;& JP-A-61126861
- PATENT ABSTRACTS OF JAPAN, vol. 7, no.4 (E-151)(1149), 8 January 1983; & JP-A-57164585
- PATENT ABSTRACTS OF JAPAN, vol.10, no. 184 (E-415)(2240), 27 June 1986;& JP-A-61032469
- CONFERENCE RECORD OF THE 19TH IEEE PHOTOVOLTAIC SPECIALISTS CONFERENCE, New Orleans, 4-8 May 1987, pages 485-488, New York, US; C.A.KITCHEN et al.: "CMZ-A new generation of solar cell coverglass"

## Description

### FIELD OF THE INVENTION

The present invention relates in general to the structure or mounting of solid state image pickup elements used for reading an image or the like, and in particular to the structure or mounting of solid state image pickup devices having a plurality of such elements arranged in a line.

Specifically, the present invention relates to a method of mounting solid state image pickup elements formed by a transparent substrate chip having photoelectric converting elements formed therein, which is cut from a transparent substrate having photoelectric converting elements formed therein. More specifically, the present invention relates to measures to achieve improvements in accuracy and reliability of the structure of mounting of such devices, and provides an elongated solid state image pickup device.

### BACKGROUND OF THE INVENTION

Prior art solid state image pickup devices of the wide area type are exemplified by the following three examples:

### Example 1

Laid-open Japanese Patent Application No. 86363/1984, for example, shows a staggered arrangement of a large number of charge-coupled device (CCD) chips formed in a single crystal silicon integrated-circuit (IC), which is associated with an external electrical circuit which performs complicated operations including delaying of a signal in a manner such that the staggered arrangement appears as if it were a straight arrangement.

### Example 2

Laid-open Japanese Patent Application No. 126861/1986, for example, shows an arrangement comprising a row of IC chips or the like, in which the photoelectric converting elements located at chip ends are largely different in form and structure from the other photoelectric converting elements.

### Example 3

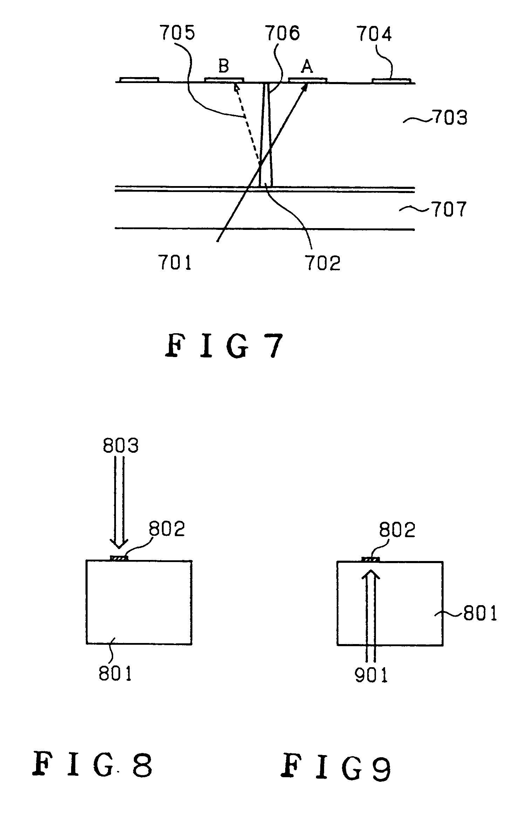

A solid state image pickup device is known, which comprises a transparent substrate, typically of a glass such as, for example, quartz glass or boro-silicate glass, having photoelectric converting elements formed thereon. Solid state image pickup devices of such type may be classified, according to the manner of incidence of light, into the following two categories:
a) an arrangement in which light 803 enters the device at the surface of a substrate 801 on which photoelectric converting elements 802 are formed, as shown in Fig. 8; and
b) an arrangement in which light 901 enters the device through the transparent substrate 801, as shown in Fig. 9.

The second arrangement b) is superior in the following respects. That is, the second arrangement b) does not require so severe consideration on the optical transparency of the upper surface of the photoelectric converting elements, as compared to the first arrangement a) which requires the surface to be sealed by glass, for example, of excellent flatness. Its protective coating or protective mold may be selected from a wide variety of known coatings or molds, and a highly reliable device can be produced. The structure of the photoelectric converting element may also be selected from a wide variety of known structures.

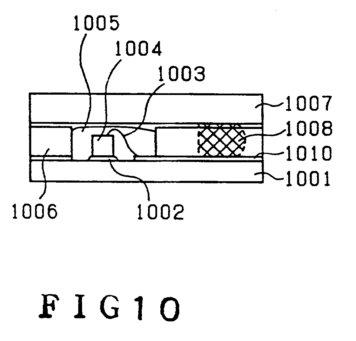

For these reasons, the second arrangement b) is usually employed, and it is conceivable to employ a particular arrangement shown in Fig. 10. A transparent substrate chip 1004 with photoelectric converting elements formed thereon is fixed to a transparent support 1001 using a fixing agent 1002, the photoelectric converting elements being connected to a circuit pattern 1010 on a mounting substrate by means of wires 1003 of aluminum, gold, or the like. Incident light passes through the transparent support and the transparent substrate chip and strikes the photoelectric converting elements. Further, a structure 1006 is provided for preventing the protective mold 1005 from flowing. The photoelectric converters and wires are potted in the protective mold, which is usually of an organic polymeric material. Driver circuits, preamplifier circuits 1007, or the like are formed on a printed circuit board and are connected by a connector 1008.

With the prior art, however, there are the following problems.

In the case of the prior art example 1, it is easy to arrange the chip connection associated with the in-line disposition, in which a plurality of chips are arranged in a line, since the chips are disposed in a staggered manner. Also, it is not necessary to modify the form of structure of the photoelectric converting segments in the chip ends. There is, however, a serious problem in that if it has more than two spaced rows of photoelectric converting segments, it is necessary to rearrange them into a single row. Specifically, an additional external device is required to perform complicated electrical operations including the operation of delaying a signal, and such additional device is provided within the chips, for example. In addition, since the imaging segments are spaced in the secondary scanning direction, restriction on optical elements such as lenses are large. Further, it can have little degree of freedom in the start and stop of reading and thus its application to facsimile telegraphs is limited. Thus, it has a problem in that it is generally costly and difficult to utilize.

In the case of the prior art example 2, in which a plurality of IC chips are disposed in a line, the pitch between the photoelectric converting elements is made constant by arranging, at chip ends, photoelectric converting elements largely different in form or structure from the other photoelectric converting elements. In this example, the continuity at the chip connection ends is not complete. To ensure the continuity, special electrical processes are required.

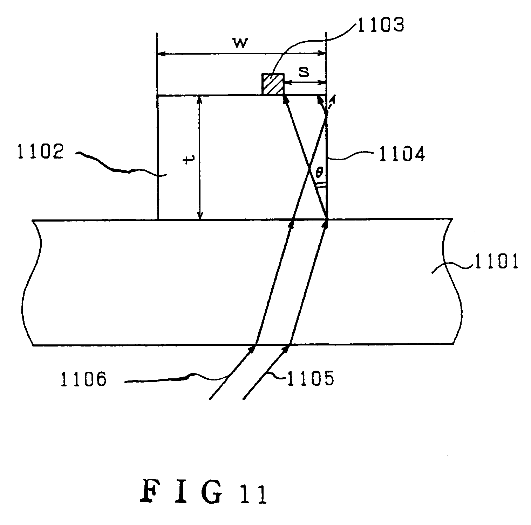

The arrangement of the prior art example 3 has the following problems:
(1) Since light is introduced into the device through a transparent substrate having photoelectric converting elements formed thereon, it is expected that the passage of light will be complicated. Our experiments showed that, in accordance with the arrangement, irregular reflection is likely to occur, and stray light, for example, will degrade the resolution or gradient, limiting the reading speed. To avoid this, the following arrangement is also thinkable. That is, the transparent substrate chip 1102 having photoelectric converting elements 1103 formed thereon is given a structure whose cross section is shown in Fig. 11, in which

   $\text{s > t* tan ϑ}$

   where ϑ is the maximum angle of incidence of light, so that stray light from sides 1104, such as incident rays of light 1105 or 1106 shown, cannot enter the photoelectric converting elements. However, if "t" is 1 mm and ϑ =15°, for example, then "s" must be larger than 0.26 mm, which means that a useless region must be present.
(2) Since a transparent substrate chip having photoelectric converting elements formed thereon is fixed on a transparent support, light will pass through the transparent support and then enter the solid state image pickup device. Therefore, the support and the fixing agent must be transparent, and various requirements are imposed on their optical characteristics, such as refractive index. Particularly, in the case of an in-line arrangement of transparent substrate chips having a plurality of photoelectric converting elements formed thereon, the photoelectric converting elements are located in the close vicinity of the connection therebetween, and thus many requirements exist concerning the optical characteristics at the connection.
(3) The transparent substrate chips having the photoelectric converting elements formed thereon and the transparent support are commonly made of different materials. For example, the transparent substrate chips having the photoelectric converting elements formed thereon are made of a highly heat-resisting quartz substrate, while the support is made of a cheap glass, such as soda glass or boro-silicate glass, since it has a wide surface area. Thus, their coefficients of thermal expansion are different by about two orders of magnitude, and, although they are important parts through which light is conducted, separation or breakage is likely to take place therebetween, and the reliability is thus very low. In view of such conditions as considered together with (2) noted above, it has been considered impossible to realize such arrangement.
(4) It is difficult to mount the elements on the transparent support, and driver circuits, preamplifier circuits, or the like must be prepared separately.
(5) Suitable structures for preventing the flow of the protective mold and manufacturing steps for adding such structures are necessitated.

### SUMMARY OF THE INVENTION

It is therefore an object of the invention to solve the above-mentioned problems, so as to provide a wide-area type solid state image pickup device, particularly a solid state image pickup device of the in-line type in which element chips are arranged in a line, which is equal in optical and electrical continuity to a single-line solid state image pickup device, and which is of high precision, high reliability, easy to use, of low costs, and compact in structure.

The solid state image pickup device according to one aspect of the present invention comprises: a transparent support; one or more transparent substrate chips mounted on the support; one or more photoelectric converting elements formed on the transparent substrate chips; a fixing agent for fixing the transparent substrate chips, at the face opposite to the face on which the photoelectric converting elements are formed, to the support at one end thereof; and an anti-reflection mold for covering the transparent substrate chips on at least the sides thereof, the refractive index of the anti-reflection mold being equal to or larger than that of the transparent substrate chips.

In one embodiment, the transparent substrate chips are made of quartz glass, and a silicone resin having a refractive index equal to or higher than 1.465 is used as the anti-reflection mold.

According to a second aspect of the present invention, the solid state image pickup device comprises: a transparent support; two or more transparent substrate chips mounted on the support in a manner such that a plurality of photoelectric converting elements formed on the transparent substrate chips are arranged in a straight line; a fixing agent for fixing the transparent substrate chips, at the face opposite to the face on which the photoelectric converting elements are formed, to the support at one end thereof; an anti-reflection mold for covering the transparent substrate chips on at least the sides thereof; and a filler for filling the gaps between the opposing faces of adjacent transparent substrate chips, the anti-reflection mold and the filler having a refractive index equal to or higher than that of the transparent substrate chips.

In an embodiment according to the second aspect of the present invention, the filler and the anti-reflection mold are of the same material.

In another embodiment according to the second aspect of the present invention, the filler and the fixing agent are of the same material.

According to a third aspect of the present invention, the solid state image pickup device comprises: a support which is a transparent plastic film; one or more transparent substrate chips arranged on the plastic film; one or more photoelectric converting elements formed on the transparent substrate chips; an insulating material substrate having holes bored therethrough, the holes being sized to match the transparent substrate chips; a fixing agent for fixing both of the transparent substrate chips, on the face thereof on which the photoelectric converting elements are not formed, and the insulating material substrate, on one face thereof, to the plastic film on one face thereof, the transparent substrates being located in the holes; and a reflecting mold for covering the transparent substrate chips on at least the sides thereof, the reflecting mold having a refractive index equal to or higher than that of the transparent substrate chips.

In one embodiment, a conductor pattern is formed on the face of the insulating material substrate which is not in contact with the fixing agent, the photoelectric converting elements formed on the transparent substrate chips being connected with the conductor pattern.

In another embodiment, the fixing agent has a refractive index equal to or higher than that of the transparent substrate chips.

In a still another embodiment, the fixing agent has a modulus of elasticity which decreases as the temperature rises.

In a further embodiment, the reflecting mold comprises one or more organic polymer materials.

In another embodiment, the organic polymer materials have a shore hardness whose value is equal to or lower than 20 after being hardened.

In another embodiment, the organic polymer materials are reactive polymers.

In another embodiment, the organic polymer materials are silicone materials.

### BRIEF DESCRIPTION OF THE DRAWINGS

The present invention will now be described, by way of example, with reference to the accompanying drawings, in which:
Figs. 1a and 1b are a schematic transverse section and a plan view, respectively, of an embodiment of the solid state image pickup device according to the present invention;
Figs. 2a and 2b are a schematic plan view and a schematic longitudinal sectional view, respectively of an embodiment of the present invention, in which two transparent substrate chips are arranged in a straight line;
Fig. 3 is another longitudinal sectional view of an embodiment of the present invention, in which two transparent substrate chips are arranged in a straight line;
Fig. 4 is a sectional view showing measures to prevent stray light from taking place due to the relation between refractive indices of transparent substrate chips and a fixing agent;
Figs. 5a and 5b are a cross sectional view and an overall view, respectively, of an embodiment of the solid state image pickup device according to the present invention;
Fig. 6 is a graph showing the reliability of organic polymer materials as a function of hardness.
Fig. 7 is an enlarged partial longitudinal cross section of an embodiment according to the present invention, showing two transparent substrate chips arranged in a straight line, showing the junction between the two chips;
Figs. 8 and 9 are diagrams showing two different passages in which light will enter the photoelectric converting elements;
Fig. 10 is a cross section of a prior art solid state image pickup device; and
Fig. 11 is a prior art technique for preventing stray light from sides of a transparent substrate chip on which photoelectric converting elements are formed;

### DETAILED DESCRIPTION OF PREFERRED EMBODIMENTS

### First Embodiment

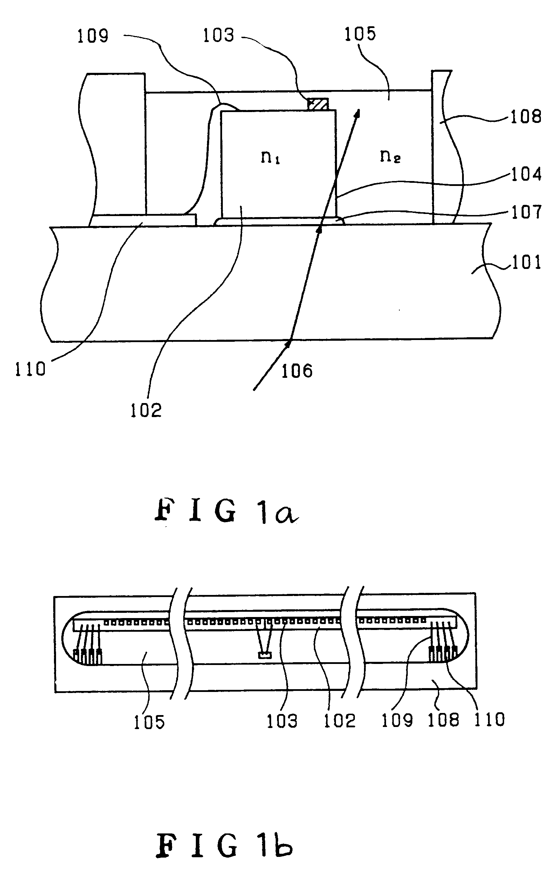

Figs. 1a and 1b are a schematic transverse section and a plan view, respectively, of an embodiment of the solid state image pickup device according to the present invention. A transparent support 101 is made of barium boro-silicate glass. A transparent substrate chip 102, which is made of quartz having a refractive index of 1.46, is fixed to one face of the support using a fixing agent 107 which is an ultraviolet-hardened acrylic adhesive. The transparent substrate chip is covered on the sides and top thereof by an anti-reflection mold 105 which comprises an addition-polymerized silicone resin having a refractive index of 1.49. The transparent substrate chip 102 is electrically connected with a conductive pattern 110 on transparent support 101 by an aluminum wire 109. For applying anti-reflection mold 105, a dam 108, which is to be its container, is provided on the transparent support.

In the above construction, it is not always necessary to provide the anti-reflection mold. Without the anti-reflection mold, however, most of the light rays 106 incident on the sides 104 of the transparent substrate chip will be scattered at the interface, thereby stray light is generated which will degrade the characteristics of the elements, since incident light rays are guided to the photoelectric converting elements 103 through the transparent support and the transparent substrate. Therefore, it is desirable to cover the transparent substrate chip at least on the sides thereof.

Here, the principal requirement on the anti-reflection mold is concerned with its refractive index. Specifically, assuming that the refractive index of the transparent substrate having the photoelectric converting elements formed thereon is n₁ and the refractive index of the anti-reflection mold is n₂, there must be the following relation:

$\text{n₁≦ n₂.}$

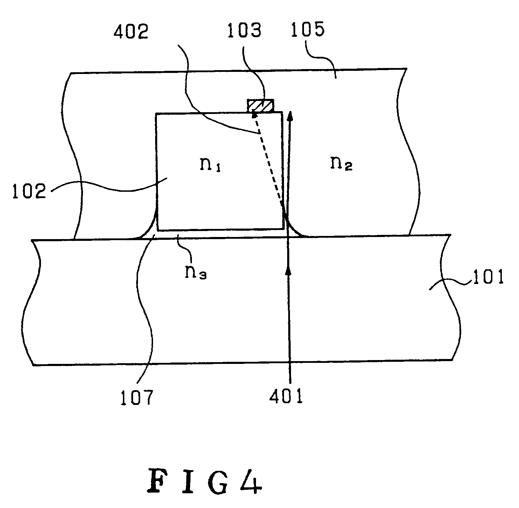

Such relation must be satisfied within the used wave length range and within the used temperature range, and n₁ and n₂ preferably have as close values as possible. Further, if the refractive index of fixing agent 107 is represented as n3, the following relation is desirable: n2≧n3. This is because if these relations are broken as shown in Fig. 4, incident light 401 passing through transparent support 101, which should go straight intrinsically, is scattered to cause stray light 402. Consequently, such light is liable to enter into photoelektric converting element 103. The material of the mold may be colored, and may contain inorganic fillers, as long as the above noted relation holds. To improve the reliability in operation of the elements, the material should preferably have a function of protecting the photoelectric converting elements.

In accordance with this embodiment, the above-noted problem 1 may be easily solved. That is, even if the passage of incident light is formed by a complicated structure and the cross section of the transparent substrate carrying the photoelectric converting elements is the required minimum value, stray light caused by irregular reflection of light will hardly take place and thus it is possible to avoid significant decrease in the resolution or gradient of the photoelectric converting elements.

Therefore, it is possible to achieve an improvement in the reading speed of the photoelectric converting elements.

### Second Embodiment

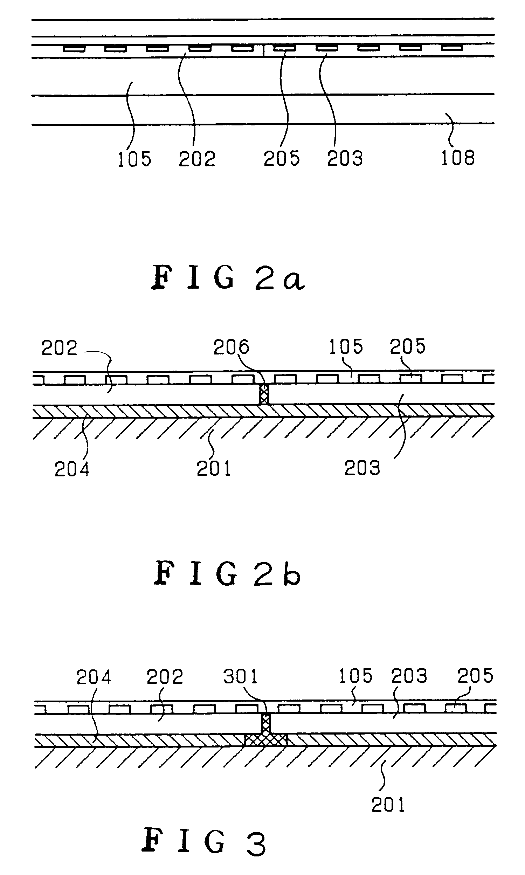

The arrangement of the first embodiment described above may be applied to a solid state image pickup device which is a second embodiment of the invention and which comprises two transparent substrate chips arranged in a substantially straight line, the chips having photoelectric converting elements formed thereon. The structure of the second embodiment of the solid state image pickup device is shown in Figs. 2a and 2b which are a schematic plan view and a schematic longitudinal cross section, respectively, of the embodiment.

The transparent substrate chips 202 and 203 of quartz having photoelectric converting elements 205 formed thereon are fixed to a transparent support 201 of low alkali glass by means of an ultraviolet-hardened urethane-modified acrylic fixing agent 204. Further, an addition-polymerized silicone resin having a refractive index of 1.52 is used as the anti-reflection mold 105 to cover the transparent substrate chips. Further, an ultraviolet-hardened acrylic resin having a refractive index of 1.47 is charged as a filler 206 between the adjacent faces of the two transparent substrate chips and is previously hardened before being fixed to the transparent support. 108 is a dam as previously mentioned.

The particularly important properties of the above-mentioned filler are the adhesive strength and refractive index.

As mentioned previously under the numerical headings (2) and (3), since in many cases the two transparent substrate chips and the transparent support are made of different materials and thus have different values of coefficient of linear expansion, the transparent support may expand and pull the transparent substrate chips at high temperatures, causing a large tensile stress at the interface 206 between the two transparent chips. If the adhesive strength is small at the interface, then a separation will take place there at high temperatures, which separation will scatter light passing through the interface, and thus optical uniformity is broken there; for example, part of the elements can perceive "black" although the "black" should essentially be perceived as "white". Therefore, the filler is required to have an adhesive strength which is sufficiently large to well withstand the stress.

The optical properties of the filler are considered here. In some cases, since the interface 706 between the two transparent substrate chips 703 lies in the passage of incident light, as shown in Fig. 7, the filler is required to have optical properties similar to those of the transparent substrate chips mentioned in the above description of the first embodiment. Thus, assuming that the transparent substrate chips have a refractive index of n₁ and the filler 702 has a refractive index of n₃, the following relation:

$\text{n₁ ≦ n₃}$

must hold within the ranges of wave length and temperature within which they may be used. If the refractive index n3 of the filler 702 is smaller than refractive index n1 of the transparent substrate chip, incident light 701 from a copy or the like is reflected at interface 706 of the transparent chip 703 through support member 707 and becomes reflected light 705. Then, incident light enters into not only A of the photoelectric converting elements 704, to which the light should reach, but also into B. Further, since the interface may be considered as an optically discontinuous surface between the two transparent substrate chips, n₁ and n₃ should preferably have extremely close values and the filler should preferably have a transmission factor which is close to that of the material of the transparent substrate chips. The filler and the anti-reflection mold may be of the same material.

In accordance with this second embodiment, a solid state image pickup device having two or more transparent substrate chips substantially arranged in a straight line can have the same effects as the first embodiment.

### Third Embodiment

In the third embodiment, quartz is used as the material of the transparent substrate chips 202, 203 having photoelectric converting elements 205 formed thereon, and Neoceram available from Nihon Denki Glass Corp. is used as the material of the transparent support 201. Also, as shown in Fig. 3, an ultraviolet-hardened acrylic resin having a refractive index of 1.48 is charged as a filler 301 between the adjacent faces of the two transparent substrate chips, and a protruding portion of the filler serves, together with a sticky ultraviolet-hardened urethane-modified acrylic fixing agent 204, as an adhesive for fixation to a transparent support 201. The fixing agent used in this embodiment is an adhesive which has a modulus of elasticity whose value decreases as the temperature rises; the value is 2 kp/cm^{2*} at room temperatures, and it decreases to one half of such value at 80°C.

One important thing in the embodiment lies in the properties of the fixing agent for fixing the transparent substrate chips to the transparent support.

In the foregoing second embodiment, the above-mentioned problem (3) is solved by charging into the interface a filler having an adhesive strength which is large enough to withstand the tensile stress which can take place at the interface. In the third embodiment, however, to solve the problem (3), the tensile stress which can take place at the interface is made as small as possible by using a fixing agent which has a modulus of elasticity whose value decreases as the temperature rises.

The fixing agent used in accordance with the present invention preferably contains a sticky component, such as *200 kPa silicone, which does not contribute to the adhering function of the agent, and the adhesive components of the agent should be ones whose hardening will be accelerated by heat to an as small degree as possible.

### Fourth Embodiment

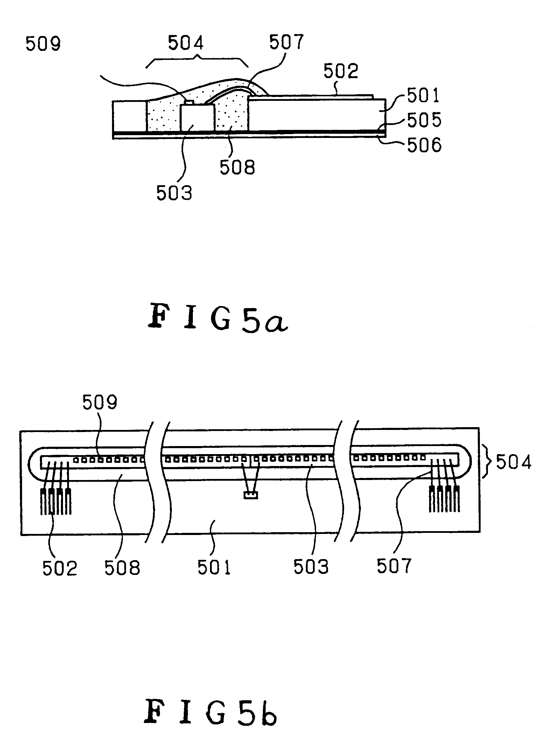

Figs. 5a and 5b are a schematic cross sectional view and a schematic plan view of a solid state image pickup device to which the present invention is applied.

A glass-epoxy laminated plate of 1.6 mm in thickness was used as an insulating material substrate 501, on which a conductor pattern 502 is formed and driver circuits and preamplifier circuits are provided. Further, holes 504 are provided which are sized such that they can surround a transparent substrate chip 503 which is made of quartz having a refractive index of 1.46 and on which photoelectric converting elements are formed. A photoelectric converting element 509 is formed on the transparent substrate chip 503. A polyester (polyethylene terephthalate) film to which a fixing agent 505 comprising a silicone adhesive is applied is used as a support 506, two transparent substrate chips and the insulating material substrate being aligned together and fixed on the sticky surface of the support. Then, the transparent substrate chips and the conductor pattern on the insulating material substrate are connected by aluminum wires 507 of 35 microns in diameter, and an addition-polymerized silicone resin having a refractive index of 1.47 is applied to the surfaces and sides of the transparent substrate chips and is charged into the wiring region as an anti-reflection mold 508 which has the effects of indication and protection.

In accordance with the present embodiment, it is possible to solve the above-mentioned problem (4) that the previously mentioned transparent substrate chips having holes which can surround the transparent substrate chips cannot be mounted on the same substrate on which driver circuits and preamplifier circuits are provided, and moreover it is possible to solve the above-mentioned problem (5) that suitable structures for preventing the flow of the protective mold and manufacturing steps for adding such structures are necessitated. Further, since the used materials have similar properties with those used in the first, second and third embodiments, the fourth embodiment includes measures to solve the problems (1), (2) and (3).

Now, the used materials will be described.

The material of the insulating material substrate 501 may be either organic or inorganic, but may preferably be a BT resin-glass laminated plate such as, for example, the one available from Mitsubishi Gas Chemical Corp.. From the viewpoint of workability for boring, for example, organic substrates are preferred, while in view of heating processes such as soldering, highly heat-resistant materials such as, for example, a glass-epoxy laminated plate and a super-engeneering plastics, are preferred. A still more compact arrangement can be achieved by mounting IC's, resistors, capacitors and other circuit components on the substrate surface.

The film used as the support 506 may be other than the previously mentioned film; for example, a polyimide tape with an adhesive available from Sumitomo Three M Corp., for example, or a polyethersulphon (PES) film having coated thereon an epoxy resin adhesive or the ultraviolet-hardened acrylic adhesive used as the fixing agent at the connection may be used as the film. The PSM film should preferably be used together with a fixing agent. Of course, a glass plate having coated thereon an adhesive as a fixing agent may be used and fixed.

The anti-reflection mold 508 may be of a thermosetting acrylic resin having a refractive index of 1.51, an ultraviolet-hardened urethane-modified acrylic resin having a refractive index of 1.48, or a moisture-hardened silicone resin.

### Fifth Embodiment

In the fourth embodiment, a BT resin-glass laminated plate of 2.0 mm in thickness was used as the insulating material substrate, on which a conductor pattern was formed and which was bored to provide holes therethrough sized to be able to surround a transparent quartz substrate chip having photoelectric converting elements formed thereon. Subsequently, an ultraviolet-hardened acrylic adhesive was applied as an fixing agent to a support comprising a polyethersulphon (PES) film, and the insulating material substrate and the transparent substrate chips having photoelectric converting elements formed thereon were positioned relative to one another on the support film and fixed thereto. The pattern on the transparent substrate chips having photoelectric converting elements formed thereon was connected with the pattern on the insulating material substrate by means of aluminum wires, and a silicone gel having a shore hardness of zero was charged as an anti-reflection mold.

As mentioned in connection with the fourth embodiment, various combinations of materials are possible in accordance with present invention. The principal materials are the transparent substrate chips having photoelectric converting elements formed thereon, and the insulating material substrate.

The quartz glass (transparent substrate chips: two chips of more than 100 mm were connected) used in the present embodiment has a coefficient of thermal expansion which is by more than two orders of magnitude different from that of the BT resin-glass laminated substrate (i.e. insulating material substrate); where the same material is used, the present embodiment is not important. In this arrangement, therefore, when the device is operated at high temperatures of about 60°C, or when the device is left at high temperatures of about 80°C, they will exert very large forces on one another. Particularly, the aluminum wires connecting them will undergo very large bending forces and, in the worst case, they will be broken to open. To solve such problem, the properties of the organic polymer material as the anti-reflection mold, in particular the hardness reached after hardening, are found to be important. Specifically, the hardness after hardening should be equal to or lower than shore A 20. In the present embodiment, the transparent substrate chips were covered on the sides and connected faces thereof by a silicone gel having a hardness of shore A 0 after hardening. Here, the filler can have satisfactory reliability and performance even if it comprises a single material (silicone) instead of the materials used in the second embodiment and having a large adhesive strength. Also, a polyethersulphon (PES) film coated with an epoxy resin adhesive, or a single-liquid condensed silicone of a shore hardness A 20 could be used.

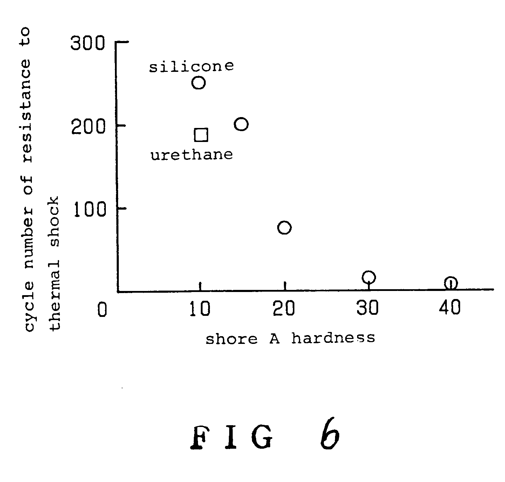

The present embodiment has achieved improvements in reliability, particularly in resistance to thermal shock, in addition to the effects as mentioned in the description of the fourth embodiment. Fig. 6 shows the relation between the resistance to thermal shock (expressed by the life cycle number from -30°C to 70°C) and the shore A hardness h for different materials exemplified by a silicone resin and an urethane resin.

Usually, the material used will not be different in coefficient of thermal expansion from one another by a degree which is more extensive than the above noted materials, but if the difference is more extensive than the above mentioned, then the hardness should further be decreased. Of course, if the overall length is longer than the above noted (250 mm), then the hardness should also be decreased but, not so significant variations were found up to 350 mm.

If the optical properties of the connection region are the most preferential matters, then an ultraviolet hardened acrylic resin, for example, having required optical properties may be used only in the connection region. The foregoing may be applicable to the arrangement of the first embodiment and can of course achieve similarly excellent effects.

### Sixth Embodiment

In a sixth embodiment, materials substantially the same as those used in the fifth embodiment were used except that a silicone gel which hardens at 80°C was used as the anti-reflection mold. In accordance with this embodiment in which the hardening temperature of the organic polymer material is limited to a particular value, an extensive improvement in reliability can advantageously be achieved for an in-line arrangement of a plurality of transparent substrate chips having a plurality of photoelectric converting elements formed therein. Specifically, it has been found that the device can maintain excellent properties in a high-temperature shelf test at 60 - 80°C for more than 1,500 hours (here, the reliability is estimated at the maximum quality assurance condition of 80°C required for office automation devices such as usual solid state image pickup devices).

The present embodiment may be applicable to the arrangement in which a resin is charged into the interface between the connected ends of transparent substrate chips having photoelectric converting elements formed thereon as well as to other arrangements. However, it has been found that the present embodiment is particularly useful when applied to the charging arrangement. Specifically, as to the hardening, the present invention is characterized in that the atmosphere is heated at temperatures equal to or higher than 40°C during irradiation of ultraviolet, and that a reactive polymer material is used as the organic polymer material. It is the best to use at temperatures within the range of from 50 to 85°C. In the case of ultraviolet-hardened urethane-modified acrylic resins which can also be hardened by heating, it has been found that irradiation of ultraviolet in an atmosphere of temperatures equal to or higher than 40°C (50 - 80°C) followed by a heating operation at a required temperature for a required length of time will provide satisfactory hardening. A moisture-hardened condensed silicone is preferably hardened in an atmosphere at temperatures equal to or higher than 40°C, such as, for example, at 55°C, 90%. Thermally hardened materials, such as, for example, a thermosetting addition-polymerized silicone resin or thermosetting acrylic resin, essentially require temperatures equal to or higher than 90°C for hardening; however, in accordance with the invention, they may also be hardened either by (1) causing a hardening process to advance, at temperatures of from 50 to 85°C at which hardening begins to take place, and for a long time (a time longer than the time which is required for hardening at temperatures equal to or higher than 90°C), or by (2) heating to a higher temperature essentially required for hardening after a temporary hardening in a similar atmosphere (50 - 85°C). Either process is applicable. Such hardening process will provide a satisfactory result for an 80°C-hardening reactive resin.

Even in the case of the fifth embodiment, for example, at high temperatures of from 60 to 80°C large tensile stresses will take place at the connection between the transparent substrate chips having photoelectric converting elements formed thereon. To allow the connection to withstand the stresses, (1) the hardening atmosphere is maintained at high temperatures so that the stresses appearing in the connection between the transparent substrate chips carrying the photoelectric converting elements will be compressive stresses at ordinary temperatures, and (2) an organic polymer material is used as the reactive polymer material. These measures make stable the connection between the transparent substrate chips carrying the photoelectric converting elements.

The foregoing ideas may also be applicable to the second embodiment. That is, a hardening process at temperatures equal to or higher than 40°C, particularly from 50 to 85°C, may be carried out in a manner as described above in order to harden the organic polymer or the agent (particularly those designated by reference numerals 204 and 205 in Fig. 2). Then, the organic polymer is reactive, and posess an additional function of fixing the connection between the transparent substrate chips carrying the photoelectric converting elements.

## Claims

1. A solid state image pickup device, comprising:
a transparent support (101); at least one transparent substrate chip (102) mounted on the support; one or more photoelectric converting elements (103) formed on each transparent substrate chip; a fixing agent (107) for fixing each transparent substrate chip, at its face opposite to a face on which the photoelectric converting elements are formed, to one face of the support; and an anti-reflection mold (105) for covering each transparent substrate chip on at least the sides thereof, the refractive index of the anti-reflection mold being equal to or larger than that of each transparent chip.

2. The device as claimed in claim 1, in which the transparent substrate chips are made of quartz glass, and a silicone resin having a refractive index equal to or higher than 1.465 is used as the anti-reflection mold.

3. A solid state image pickup device, comprising:
a transparent support (201); two or more transparent substrate chips (202, 203) mounted on the support in a manner such that a plurality of photoelectric converting elements (205) formed on the transparent substrate chips are arranged in a straight line; a fixing agent (204) for fixing the transparent substrate chips, each at its face opposite to a face on which the photoelectric converting elements are formed, to one face of the support; an anti-reflection mold (105) for covering the transparent substrate chips on at least the sides thereof; and a filler (206) for filling the gaps between the opposing faces of adjacent transparent substrate chips, the anti-reflection mold and the filler having a refractive index equal to or higher than that of the transparent substrate chips.

4. The device as claimed in claim 3, in which the filler and the anti-reflection mold are of the same material.

5. The device as claimed in claim 3, in which the filler and the fixing agent are of the same material.

6. A solid state image pickup device, comprising:
a support which is a transparent plastic film (506); at least one transparent substrate chip (503) arranged on the plastic film; one or more photoelectric converting elements (509) formed on each transparent substrate chip; an insulating material substrate (501) having a hole (504) bored therethrough, the hole being sized to match said at least one transparent substrate chip; a fixing agent (505) for fixing each transparent substrate chip, at one face thereof on which the photoelectric converting elements are not formed, and the insulating material substrate, at one face thereof, to one face of the plastic film, each transparent substrate chip being located in the hole (504); and an anti- reflecting mold (508) for covering each transparent substrate chip on at least the sides thereof, the anti-reflecting mold having a refractive index equal to or higher than that of each transparent substrate chip.

7. The device as claimed in claim 6, in which a conductor pattern (502) is formed on the face of the insulating material substrate which is not in contact with the fixing agent, the photoelectric converting elements formed on the transparent substrate chips being connected with the conductor pattern.

8. The device as claimed in any of claims 1, 3 or 6, in which the fixing agent has a refractive index equal to or higher than that of the transparent substrate chips.

9. The device as claimed in any of claims 1, 3 or 6, in which the fixing agent has a modulus of elasticity which decreases as the temperature rises.

10. The device as claimed in any of claims 1, 3 or 6, in which the reflecting mold comprises one or more organic polymer materials.

11. The device as claimed in claim 10, in which the organic polymer materials have a shore hardness whose value is equal to or lower than 20 after being hardened.

12. The device as claimed in claim 10, in which the organic polymer materials are reactive polymers.

13. The device as claimed in claim 10, in which the organic polymer materials are silicone materials.

## Patentansprüche

1. Festkörper-Bildaufnahmevorrichtung, umfassend:
einen transparenten Träger (101), wenigstens ein auf dem Träger montiertes Plättchen (102) transparenten Substrats, eine oder mehre fotoelektrische Wandlerelemente (103), die auf jedem Plättchen transparenten Substrats ausgebildet sind, ein Befestigungsmittel (107) zur Befestigung jedes Plättchens transparenten Substrats an seiner Fläche, die einer Fläche gegenüberliegt, auf der die fotoelektrischen Wandlerelemente ausgebildet sind, an einer Fläche des Trägers, und ein Antireflexionsformteil (105) zum Bedecken jedes Plättchens transparenten Substrats wenigstens an dessen Seiten, wobei der Brechungsindex des Antireflexionsformteils gleich oder größer ist als derjenige jedes transparenten Plättchens.

2. Vorrichtung nach Anspruch 1, bei der die Plättchen transparenten Substrats aus Quarzglas hergestellt sind und ein Silikonharz mit einem Brechungsindex gleich oder größer als 1,465 als das Antireflexionsformteil verwendet wird.

3. Festkörper-Bildaufnahmevorrichtung, umfassend:
einen transparenten Träger (201), zwei oder mehr Plättchen (202, 203) transparenten Substrats, die auf dem Träger in einer Weise montiert sind, daß eine Vielzahl von auf den Plättchen transparenten Substrats ausgebildeten fotoelektrischen Wandlerelementen (205) in einer geraden Linie angeordnet sind, ein Befestigungsmittel (204) zur Befestigung der Plättchen transparenten Substrats, jedes an seiner Fläche, die einer Fläche gegenüberliegt, auf der die fotoelektrischen Wandlerelemente ausgebildet sind, an einer Fläche des Trägers, ein Antireflexionsformteil (105) zum Bedecken der Plättchen transparenten Substrats wenigstens an deren Seiten, und einen Füllstoff (206) zum Füllen der Spalte zwischen gegenüberliegenden Flächen benachbarter Plättchen transparenten Substrats, wobei das Antireflexionsformteil und der Füllstoff einen Brechungsindex aufweisen, der gleich oder größer ist als derjenige der Plättchen transparenten Substrats.

4. Vorrichtung nach Anspruch 3, bei der der Füllstoff und das Antireflexionsformteil aus demselben Material bestehen.

5. Vorrichtung nach Anspruch 3, bei der der Füllstoff und das Befestigungsmittel aus demselben Material bestehen.

6. Festkörper-Bildaufnahmevorrichtung, umfassend:
einen Träger, bei dem es sich um einen transparenten Plastikfilm (506) handelt, wenigstens ein Plättchen (503) transparenten Substrats, das auf dem Plastikfilm angeordnet ist, ein oder mehrere fotoelektrische Wandlerelemente (509), die auf jedem Plättchen transparenten Substrats ausgebildet sind, ein Isoliermaterialsubstrat (501) mit einem durch dieses gebohrten Loch (504), dessen Größe so bemessen ist, daß es dem wenigstens einen Plättchen transparenten Substrats angepaßt ist, ein Befestigungsmittel (505) zur Befestigung jedes Plättchens transparenten Substrats an einer Fläche desselben, auf der die fotoelektrischen Wandlerelemente nicht ausgebildet sind, und des Isoliermaterialsubstrates, an einer Fläche desselben, an einer Fläche des Plastikfilms, wobei jedes Plättchen transparenten Substrats in dem Loch (504) angeordnet ist, und ein Antireflexionsformteil (508) zum Bedecken jedes Plättchens transparenten Substrats wenigstens an dessen Seiten, wobei das Antireflexionsformteil einen Brechungsindex gleich oder größer als derjenige jedes Plättchens transparenten Substrats aufweist.

7. Vorrichtung nach Anspruch 6, bei der ein Leitermuster (502) auf der Fläche des Isoliermaterialsubstrats ausgebildet ist, die nicht mit dem Befestigungsmittel in Kontakt steht, wobei die auf den Plättchens transparenten Substrats ausgebildeten fotoelektrischen Wandlerelemente mit dem Leitermuster verbunden sind.

8. Vorrichtung nach einem der Ansprüche 1, 3 oder 6, bei der das Befestigungsmittel einen Brechungsindex gleich oder größer als der der Plättchen transparenten Substrats aufweist.

9. Vorrichtung nach einem der Ansprüche 1, 3 oder 6, bei der das Befestigungsmittel einen Elastizitätsmodul aufweist, der mit steigender Temperatur abnimmt.

10. Vorrichtung nach einem der Ansprüche 1, 3 oder 6, bei der das Relflexionsformteil ein oder mehrere organische Polymermaterialien umfaßt.

11. Vorrichtung nach Anspruch 10, bei der die organischen Polymermaterialien eine Shorehärte aufweisen, deren Wert nach dem Aushärten gleich oder geringer als 20 ist.

12. Vorrichtung nach Anspruch 10, bei der die organischen Polymermaterialien reaktive Polymere sind.

13. Vorrichtung nach Anspruch 10, bei der die organischen Polymermaterialien Silikonmaterialien sind.

## Revendications

1. Dispositif de prise de vues d'état solide, comprenant:
un support transparent (101); au moins une microplaquette (102) à substrat transparent, montée sur le support; un ou plusieurs éléments convertisseurs photoélectriques (103) formés sur chaque microplaquette à substrat transparent; un adhésif (107) pour fixer, à une face du support, chaque microplaquette à substrat transparent par sa face opposée à une face sur laquelle sont formés les éléments convertisseurs photoélectriques; et une matière moulée anti-réflexion (105) pour couvrir au moins sur ses côtés chaque microplaquette à substrat transparent, l'indice de réfraction de la matière moulée anti-réflexion étant égal ou supérieur à celui de chaque microplaquette transparente.

2. Dispositif selon la revendication 1, dans lequel les microplaquettes à substrat transparent sont en verte de quartz, et une résine de silicone dont l'indice de réfraction est égal ou supérieur à 1,465 est utilisée comme matière moulée anti-réflexion.

3. Dispositif de prise de vues d'état solide, comprenant:
un support transparent (201); deux microplaquettes (202, 203) à substrat transparent, ou davantage, montées sur le support d'une manière telle qu'une série d'éléments convertisseurs photoélectriques (205) formés sur les microplaquettes du substrat transparent sont disposés en une ligne droite; un adhésif (204) pour fixer, à une face du support, les microplaquettes à substrat transparent, chacune par sa face opposée à une face sur laquelle sont formés les éléments convertisseurs photoélectriques; une matière moulée anti-réflexion (105) pour couvrir au moins sur leurs côtés les microplaquettes à substrat transparent; et une charge (206) pour remplir les intervalles entre les faces opposées de microplaquettes adjacentes à substrat transparent, les indices de réfraction de la matière moulée anti-réflexion et de la charge étant égaux ou supérieurs à celui des microplaquettes à substrat transparent.

4. Dispositif selon la revendication 3, dans lequel la charge et la matière moulée anti-réflexion sont formées de la même matière.

5. Dispositif selon la revendication 3, dans lequel la charge et l'adhésif sont formés de la même matière.

6. Dispositif de prise de vues d'état solide, comprenant:
un support qui est un film en plastique transparent (506); au moins une microplaquette (503) à substrat transparent, disposée sur le film en plastique; un ou plusieurs éléments convertisseurs photoélectriques (509) formés sur chaque microplaquette à substrat transparent; un substrat (501) en matière isolante dans lequel est alésé un trou traversant (504), le trou étant dimensionné de façon à concorder avec ladite microplaquette au moins unique à substrat transparent; un adhésif (505) pour fixer, à une face du film en plastique, chaque microplaquette à substrat transparent par l'une de ses faces sur laquelle les éléments convertisseurs photoélectriques ne sont pas formés, et le substrat en matière isolante par l'une de ces faces, chaque microplaquette à substrat transparent étant positionnée dans le trou (504); et une matière moulée anti-réflexion (508) pour couvrir au moins sur ses côtés chaque microplaquette à substrat transparent, l'indice de réfraction de la matière moulée anti-réfléchissant étant supérieur ou égal à celui de chaque microplaquette à substrat transparent.

7. Dispositif selon la revendication 6, dans lequel une configuration conductrice (502) est formée sur la face du substrat en matière isolante qui n'est pas en contact avec l'adhésif, les éléments convertisseurs photoélectriques formés sur les microplaquettes à substrat transparent étant reliés à la configuration conductrice.

8. Dispositif selon l'une quelconque des revendications 1, 3 ou 6, dans lequel l'indice de réfraction de l'adhésif est égal ou supérieur à celui des microplaquettes à substrat transparent.

9. Dispositif selon l'une quelconque des revendications 1, 3 ou 6, dans lequel le module d'élasticité de l'adhésif diminue au fur et à mesure que la température augmente.

10. Dispositif selon l'une quelconque des revendications 1, 3 ou 6, dans lequel la matière moulée réfléchissante comprend une ou plusieurs matières polymères organiques,

11. Dispositif selon la revendication 10, dans lequel la valeur de la dureté shore des matières polymères organiques après durcissement est égale ou inférieure à 20.

12. Dispositif selon la revendication 10, dans lequel les matières polymères organiques sont des polymères réactifs.

13. Dispositif selon la revendication 10, dans lequel les matières polymères organiques sont des matières de silicone.
